# EUROPÄISCHE PATENTANMELDUNG

(11) **EP 3 351 943 A1**
(43) Veröffentlichungstag der Anmeldung: **25.07.2018**
(21) Anmeldenummer: 18305052.5
(22) Anmeldetag: 23.01.2018
(51) Int. Cl.: G01R 11/04, G01R 22/06

(54) **BEFESTIGUNGSEINRICHTUNG ZUR BEFESTIGUNG EINES ELEKTRIZITÄTSZÄHLERS**

(30) Priorität: 23.01.2017 DE 102017101194
(71) Anmelder: Hager Electro GmbH & Co. KG, 66440 Blieskastel (DE)
(72) Erfinder: ANNA, Felix, 66424 HOMBURG (DE); ZIMMERMANN, Michael, 66399 MANDELBACHTAL (DE)
(74) Vertreter: Nuss, Laurent

(57) **Zusammenfassung**

Die Erfindung betrifft eine Befestigungseinrichtung (10) zur Befestigung und Kontaktierung eines Elektrizitätszählers, insbesondere eines elektronischen Elektrizitätszählers (100). Die Befestigungseinrichtung (10) umfasst eine Leitungsführungseinrichtung (20) zur Führung wenigstens eines Phasenleiters (L) und wenigstens einen eine Signalleitung aufweisenden Stromwandler (60), wobei der Stromwandler (60) geeignet ist, auf der Signalleitung ein elektrisches Signal bereit zu stellen, welches die in dem Phasenleiter (L) fließende Stromstärke abbildet.

## Beschreibung

Die Erfindung betrifft eine Befestigungseinrichtung zur Befestigung eines Elektrizitätszählers, insbesondere eines elektronischen Elektrizitätszählers.

Befestigungseinrichtungen sind aus dem Stand der Technik, beispielsweise aus der deutschen Patentanmeldung DE 10 2011 054 412 A1 bekannt. Ein durch eine Zählertragplatte abgedecktes Gehäuse der Befestigungseinrichtung weist Einrichtungen zur Anbringung der Befestigungseinrichtung an einem Zählerkreuz einer Zählerplatzbaugruppe für den Anschluss eines herkömmlichen elektromechanischen Elektrizitätszählers auf.

Zudem sind aus dem Stand der Technik Befestigungseinrichtungen mit Stromwandler und ohne Stromwandler bekannt. Befestigungseinrichtungen ohne Stromwandler sind zur Befestigung eines Elektrizitätszählers geeignet, der selbst mit Stromwandlern ausgestattet ist. Eine Befestigungseinrichtung mit Stromwandlern ist zur Aufnahme eines Elektrizitätszählers ohne Stromwandler geeignet.

Die Leitungen, in denen der zu zählende Strom fließt, sind in der Regel elektrisch leitend mit elektrischen Anschlusselementen der Befestigungseinrichtung verbunden, wodurch ein roher konstruktiver Aufwand vorherrscht.

Es ist die Aufgabe der vorliegenden Erfindung, eine Befestigungseinrichtung bereit zu stellen, die in einfacher Weise und mit geringem konstruktivem Aufwand hergestellt, geprüft und montiert werden kann.

Die Aufgabe wird mittels einer Befestigungseinrichtung nach dem Hauptanspruch gelöst. Die Befestigungseinrichtung dient zur Befestigung- und Kontaktierung eines Elektrizitätszählers, insbesondere eines elektronischen Elektrizitätszählers. Die Befestigungseinrichtung umfasst eine Leitungsführungseinrichtung zur Führung wenigstens eines Phasenleiters und wenigstens eine eine Signalleitung umfassende Strommesseinrichtung.

Die Leitungsführungseinrichtung weist für jeden zu führenden Phasenleiter einen Leitungskanal auf, der sich im Wesentlichen entlang einer Führungsrichtung erstreckt und zwei Endabschnitte mit einen in Führungsrichtung im Wesentlichen gleichbleibenden Kanalquerschnitt umfasst, nämlich einen ersten Endabschnitt und einen in Führungsrichtung hinter dem ersten Endabschnitt angeordneten zweiten Endabschnitt.

Der Leitungskanal umfasst einen Aufnahmeabschnitt, der zwischen den Endabschnitten angeordnet ist und in welchen die Strommesseinrichtung aufgenommen ist.

Die Strommesseinrichtung ist derart in dem Aufnahmeabschnitt aufgenommen, dass ein in Führungsrichtung in den Leitungskanal eingeführter Phasenleiter derart an der Strommesseinrichtung vorbeigeführt ist oder durch die Strommesseinrichtung hindurch geführt ist, dass die Strommesseinrichtung geeignet ist, auf der Signalleitung ein elektrisches Signal bereit zu stellen, welches die in dem Phasenleiter fließende Stromstärke abbildet.

Durch die erfindungsgemäße Ausgestaltung der Befestigungseinrichtung kann eine einfache Montage erfolgen, in dem durch einfaches mechanisches Hindurchschleifen des oder der Phasenleiter(s) durch die Leitungskanäle an der Befestigungseinrichtung ein elektrisches Signal bereit gestellt werden kann, welches die in dem oder den Phasenleitern fließende Stromstärke abbildet und an den Elektrizitätszähler weitergibt. Der Phasenleiter kann dabei insbesondere als biegsames Kabel mit wenigstens einer Ader und einer um die Ader angeordneten Isolierung ausgebildet sein. Durch diese Ausgestaltung kann die in der Ader fließende Stromstärke durch die Strommesseinrichtung gemessen werden, ohne dass die Isolierung des Kabels zuvor entfernt werden muss. Durch diese Ausgestaltung lässt sich das Kabel in einfacher Weise mit der Strommesseinrichtung in Wirkverbindung bringen, indem jedes einer Phase entsprechende Kabel durch den korrespondierenden Leitungskanal gezogen wird.

Jeder Leitungskanal, insbesondere der erste Endabschnitt jedes Leitungskanals kann ausgebildet sein, um das biegsame Kabel gegenüber der Strommesseinrichtung auszurichten, d.h., um das biegsame Kabel an seine bestimmungsgemäße Endlage durch die Strommesseinrichtung hindurch oder an dieser vorbei zu führen. Dabei kann der Kanalquerschnitt insbesondere kreisförmig ausgebildet sein und das Kabel einen kreisförmigen Querschnitt aufweisen.

Das Kabel kann eine Kabelquerschnittsfläche aufweisen, die zwischen 2,5 mm² und 35 mm², vorzugsweise zwischen 10 mm² und 16 mm² beträgt.

Vorzugsweise ist die Kabelquerschnittsfläche kleiner als eine Querschnittsfläche der Endabschnitte.

In einer bevorzugten Ausgestaltung weist der Aufnahmeabschnitt einen von den Endabschnitten verschiedenen Querschnitt auf. Vorzugsweise ist die Strommesseinrichtung formschlüssig in dem Aufnahmeabschnitt aufgenommen. Weiterhin vorzugsweise ist die Strommesseinrichtung in und entgegen der Führungsrichtung formschlüssig in dem Aufnahmeabschnitt gehalten.

Alternativ kann der Phasenleiter auch als Kupferschiene ausgebildet sein.

Die Befestigungseinrichtung kann auch als Befestigungseinrichtung mit Strommesseinrichtung oder auch als Befestigungseinrichtung mit Wandler (BEW) bezeichnet werden.

In einer bevorzugten Ausgestaltung ist die Strommesseinrichtung als Stromwandler ausgebildet.

Vorzugsweise ist der Stromwandler torusförmig ausgebildet und derart in dem Aufnahmeabschnitt aufgenommen, dass ein in Führungsrichtung in den Leitungskanal eingeführter Phasenleiter durch eine Öffnung des Stromwandlers hindurch geführt ist, wobei weiterhin vorzugsweise der Stromwandler derart in dem Aufnahmeabschnitt aufgenommen ist, dass die Öffnung mit dem Leitungskanal und/oder den Endabschnitten fluchtet.

Diese Ausgestaltung ermöglicht es, die in dem Phasenleiter fließende Stromstärke präziser abzubilden. Diese Ausgestaltung erlaubt weiterhin, in einfacher Weise die in dem Phasenleiter fließende Stromstärke abzubilden, ohne dass der Phasenleiter, der vorzugsweise als Kabel vorliegt, abisoliert werden muss. Somit kann der Phasenleiter durch einfaches Hindurchführen durch die Leitungsführungseinrichtung in Wirkverbindung mit der Strommesseinrichtung gebracht werden.

In einer bevorzugten Ausgestaltung ist zwischen dem ersten Endabschnitt und dem Aufnahmeabschnitt ein erster Ausrichtungsabschnitt angeordnet, der den durch den ersten Endabschnitt in Führungsrichtung eingeführten Phasenleiter derart ausrichtet, dass dieser in Führungsrichtung an dem Stromwandler vorbeigeführt oder durch den Stromwandler hindurch geführt, vorzugsweise durch die Öffnung geführt werden kann.

Diese Ausgestaltung ermöglicht ein einfaches Einführen und mechanisches Durchschleifen des Phasenleiters durch den Leitungskanal.

Vorzugsweise ist zwischen dem Aufnahmeabschnitt und dem zweiten Endabschnitt ein zweiter Ausrichtungsabschnitt angeordnet, der den durch den ersten Endabschnitt, den Aufnahmeabschnitt und vorzugsweise die Öffnung in Führungsrichtung eingeführten Phasenleiter derart ausrichtet, dass dieser in Führungsrichtung in den zweiten Endabschnitt geführt werden kann.

Diese Ausgestaltung erleichtert weiterhin das Hindurchführen der Phasenleiter durch die Leitungsführungseinrichtung.

In einer bevorzugten Ausgestaltung ist der erste Ausrichtungsabschnitt und/oder der zweite Ausrichtungsabschnitt im Wesentlichen trichterförmig oder kegelförmig ausgebildet.

Diese Ausgestaltung erleichtert das Vorbeiführen beziehungsweise das Hindurchführen des Phasenleiters an der Strommesseinrichtung vorbei beziehungsweise durch die Strommesseinrichtung hindurch, vorzugsweise durch die Öffnung der Strommesseinrichtung hindurch.

In einer bevorzugten Ausgestaltung liegt der erste Ausrichtungsabschnitt und/oder der zweite Ausrichtungsabschnitt abschnittsweise an der Strommesseinrichtung an, um die Strommesseinrichtung in oder entgegen der Führungsrichtung formschlüssig zu halten.

Diese Ausgestaltung ermöglicht ein einfaches Verbinden der Strommesseinrichtung oder der Strommesseinrichtungen mit dem jeweiligen Leitungskanal.

Vorzugsweise umfasst die Leitungsführungseinrichtung zwei Halbschalen, die den Leitungskanal oder die Leitungskanäle bilden und die weiterhin vorzugsweise jeweils aus Kunststoff mittels Spritzguss hergestellt sind.

Diese Ausgestaltung ermöglicht es in einfacher Weise, die Leitungsführungseinrichtung herzustellen.

In einer bevorzugten Ausgestaltung umfasst die Befestigungseinrichtung wenigstens zwei Leitungskanäle, wobei der Aufnahmeabschnitt zweier benachbarter Leitungskanäle in Führungsrichtung zueinander versetzt angeordnet sind.

Diese Ausgestaltung ermöglicht es, die Befestigungseinrichtung kompakt und platzsparend auszugestalten.

Vorzugsweise umfasst die Befestigungseinrichtung wenigstens eine Spannungsabgriffsvorrichtung mit einem Dorn, wobei die Spannungsabgriffsvorrichtung derart angeordnet ist, dass der Dorn in den Leitungskanal hineinragt, um in das Kabel zum Abgriff einer in der Ader des Kabels vorherrschenden Spannung einzudringen.

Diese Ausgestaltung ermöglicht es, die in dem Phasenleiter vorherrschende Spannung an dem Elektrizitätszähler weiter zu leiten, um den verbrauchten Strom präziser bestimmen zu können.

In einer bevorzugten Ausgestaltung ist der Dorn durch eine Verschiebung der Spannungsabgriffsvorrichtung annähernd orthogonal zur Führungsrichtung in den Phasenleiter einführbar.

Vorzugsweise kann die Spannungsabgriffsvorrichtung derart angeordnet sein und der Dorn derart mit einem Gewinde versehen sein, das eine Drehbewegung des Dorns in eine translatorische Bewegung orthogonal zur Führungsrichtung überführt wird, um den Dorn in den Phasenleiter einzuführen.

Vorzugsweise ist die Spannungsabgriffsvorrichtung ausgebildet, um bei Verbinden des Elektrizitätszählers mit der Befestigungseinrichtung, insbesondere durch eine parallel zu einer Vorderseite der Befestigungseinrichtung verlaufende Verschiebebewegung, den Dorn in den Leitungskanal einzudrücken. Weiterhin vorzugsweise ist die Spannungsabgriffsvorrichtung ausgebildet, um bei Entfernen des Elektrizitätszählers von der Befestigungseinrichtung den Dorn in den Leitungskanal zu halten

In einer bevorzugten Ausgestaltung umfasst die Signalleitung der Strommesseinrichtung einen Schalter, vorzugsweise einen Mikroschalter, der geeignet ist, den durch die Signalleitung gebildeten Sekundärstromkreis zu öffnen und/oder zu schließen.

In einer alternativen Ausgestaltung kann die Signalleitung der Strommesseinrichtung eine elektronische Schaltung umfassen, die geeignet ist, den durch die Signalleitung gebildeten Sekundärstromkreis zu öffnen und/oder zu schließen.

Mittels dieser Ausgestaltung kann ermöglicht werden, das ein Auftreten hoher Spannungen im Sekundärstromkreis zu verhindern, bevor der Elektrizitätszähler mit der Befestigungseinrichtung verbunden wird und die Signalleitung an dem Elektrizitätszähler angeschlossen wird.

Vorzugsweise umfasst die Befestigungseinrichtung wenigstens eine Spannungsbestimmungsvorrichtung, wobei die Spannungsbestimmungsvorrichtung wenigstens eine eine Spannungssignalleitung umfassende Spannungsmesseinrichtung aufweist, wobei die Spannungsmesseinrichtung derart in der Leitungsführungseinrichtung aufgenommen ist, dass ein in Führungsrichtung in den Leitungskanal eingeführter Phasenleiter derart an der Spannungsmesseinrichtung vorbeigeführt ist oder durch die Spannungsmesseinrichtung hindurch geführt ist, dass die Spannungsmesseinrichtung geeignet ist, auf der Spannungssignalleitung ein elektrisches Signal bereit zu stellen, welches die in einer Ader des Phasenleiters vorherrschende Spannung abbildet.

In einer bevorzugten Ausgestaltung ist die Spannungssignalleitung oder die Spannungsabgriffsvorrichtung elektrisch leitend mit der Signalleitung der Strommesseinrichtung verbunden, um das Spannungssignal oder die in der Ader des Phasenleiters vorherrschenden Spannung auf der Signalleitung bereit zu stellen.

In einer bevorzugten Ausgestaltung umfasst die Befestigungseinrichtung eine Kontaktiereinrichtung, die geeignet ist, mit einer Anschlusseinrichtung des Elektrizitätszählers verbunden zu werden. Weiterhin vorzugsweise ist die Kontaktiereinrichtung mit der Signalleitung und/oder der Spannungssignalleitung verbunden, um das Spannungssignal oder die in der Ader des Phasenleiters vorherrschenden Spannung auf dem Elektrizitätszähler bereit zu stellen.

In einer weiteren bevorzugten Ausgestaltung kann die Befestigungseinrichtung eine Signalübertragungseinrichtung umfassen, die geeignet ist, ein Funksignal und/oder ein optisches Signal bereit zu stellen, das die in dem Phasenleiter fließende Stromstärke und/oder das Spannungssignal und/oder die in der Ader des Phasenleiters vorherrschenden Spannung abbildet. Vorzugsweise umfasst der Elektrizitätszähler eine Kommunikationseinrichtung, die geeignet ist, aus dem Funksignal und/oder dem optischen Signal eine Information über die in dem Phasenleiter fließende Stromstärke und/oder das Spannungssignal und/oder die in der Ader des Phasenleiters vorherrschenden Spannung zu gewinnen.

Alternativ oder zusätzlich kann die Signalübertragungseinrichtung ausgebildet sein, einen Umrechnungsfaktor, der dem Verhältnis zwischen der in der Signalleitung fließende Stromstärke und der in dem korrespondierenden Phasenleiter fließenden Stromstärke entspricht, mittels des Funksignals und/oder ein optischen Signals an die Kommunikationseinrichtung des Elektrizitätszählers zu übertragen. Weiterhin vorzugsweise ist der Umrechnungsfaktor in einem Speichermodul der Befestigungseinrichtung gespeichert und die Befestigungseinrichtung umfasst ferner eine Steuerungseinrichtung, die mit dem Speichermodul und der Signalübertragungseinrichtung verbunden ist, um den Umrechnungsfaktor aus dem Speichermodul zu erhalten und an die Signalübertragungseinrichtung weiterzugeben.

In einer bevorzugten Ausgestaltung kann der Elektrizitätszähler mit einer Stellschraube versehen sein und der Elektrizitätszähler ausgebildet sein, anhand einer Stellung der Stellschraube einen Umrechnungsfaktor, der dem Verhältnis zwischen der in der Signalleitung fließende Stromstärke und der in dem korrespondierenden Phasenleiter fließenden Stromstärke entspricht, zu bestimmen. Weiterhin vorzugsweise umfasst die Stellschraube des Elektrizitätszählers eine Plombiereinrichtung zur Plombierung der Stellschraube in ihrer Momentanstellung.

Einzelheiten und weitere Vorteile der erfindungsgemäßen Befestigungseinrichtung werden anhand des nachfolgend beschriebenen Ausführungsbeispiels erläutert. Dabei veranschaulichen im Einzelnen:
Fig. 1: zeigt eine schematische Darstellung einer Befestigungseinrichtung nach dem Ausführungsbeispiel;
Fig. 2: zeigt einen elektronischen Elektrizitätszähler, der zur Befestigung an der Befestigungseinrichtung gemäß Figur 1 geeignet ist;
Fig. 3: zeigt eine schematische Draufsicht zweier Halbschalen einer Leitungsführungseinrichtung der Befestigungseinrichtung nach dem Ausführungsbeispiel;
Fig. 4: zeigt eine perspektivische Ansicht der in Figur 3 gezeigten Halbschalen;
Fig. 5: zeigt eine perspektivische Ansicht der Leitungsführungseinrichtung der Befestigungseinrichtung nach dem Ausführungsbeispiel;
Fig. 6: zeigt eine Draufsicht eines einzelnen Leitungskanals der Leitungsführungseinrichtung der Befestigungseinrichtung nach dem Ausführungsbeispiel;
Fig. 7: zeigt eine perspektivische Ansicht des in Figur 6 wiedergegebenen Leitungskanals;
Fig. 8: zeigt eine schematische Ansicht der Leitungsführungseinrichtung der Befestigungseinrichtung nach dem Ausführungsbeispiel;
Fig. 9: zeigt eine Schnittansicht einer Spannungsabgriffsvorrichtung der Befestigungseinrichtung nach dem Ausführungsbeispiel;
Fig. 9a: zeigt eine Schnittansicht der Spannungsabgriffsvorrichtung der Befestigungseinrichtung in einer alternativen Ausgestaltung;
Fig. 10: zeigt eine perspektivische Schnittansicht der Befestigungseinrichtung nach dem Ausführungsbeispiel;
Fig. 11: zeigt eine Schnittansicht einer Befestigungseinrichtung, auf welcher ein elektronischer Elektrizitätszähler befestigt wird; und
Fig. 12: zeigt eine Anschlussleiste des elektronischen Elektrizitätszählers, welcher mit der Befestigungseinrichtung nach dem Ausführungsbeispiel verbunden werden kann.

Die Anmeldung betrifft eine Befestigungseinrichtung 10 zur Befestigungseinrichtung eines Elektrizitätszählers, insbesondere eines elektronischen Elektrizitätszählers 100. Die Befestigungseinrichtung umfasst eine Leitungsführungseinrichtung 20 zur Führung wenigstens eines Phasenleiters L. Die Leitungsführungseinrichtung 20 kann ebenfalls zur Führung eines Neutralleiters L ausgebildet sein.

Die Befestigungseinrichtung 10 kann mit wenigstens einer Befestigungsöffnung 11 versehen sein, in welche Hakenelemente 102 des Elektrizitätszählers einrastbar sind, um den Elektrizitätszähler 100 auf der Befestigungseinrichtung 10 zu halten.

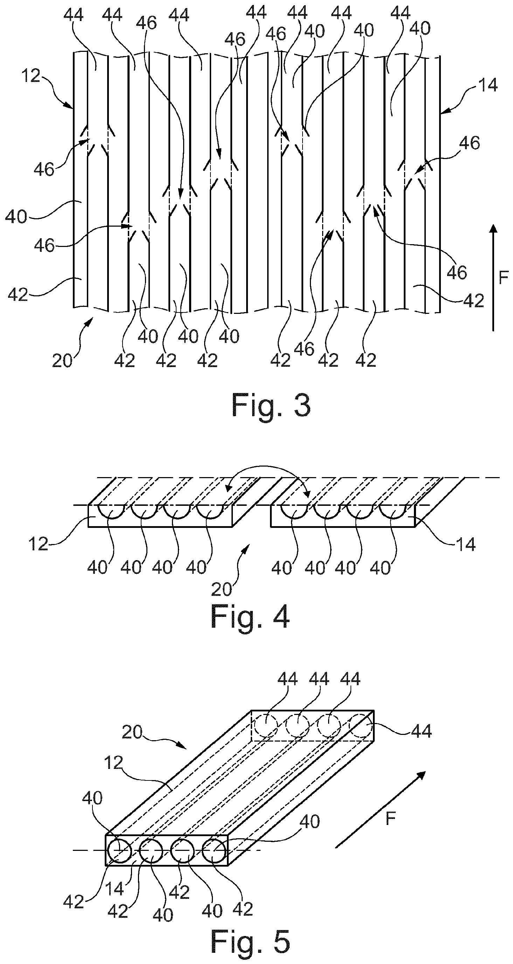

Die Leitungsführungseinrichtung 20 kann zwei Halbschalen 12, 14 umfassen, die vorzugsweise mittels Spritzguss aus Kunststoff hergestellt sind. Die Halbschalen 12, 14 können den Leitungskanal 40 bilden. Diese Ausgestaltung wird insbesondere aus den Figuren 3 bis 5 ersichtlich.

Die Befestigungseinrichtung 10 umfasst wenigstens eine als Stromwandler 60 ausgebildete Strommesseinrichtung, die mit einer Signalleitung versehen ist. Die Befestigungseinrichtung 10 kann jedoch auch mehrere Stromwandler 60 umfassen, und zwar einen für jede zu messende Stromphase, beziehungsweise einen für jeden Phasenleiter L.

Die Leitungsführungseinrichtung 20 umfasst für jeden zu führenden Phasenleiter L einen Leitungskanal 40, der sich im Wesentlichen entlang einer Führungsrichtung F erstreckt und zwei Endabschnitte 42, 44 mit einen in Führungsrichtung F im Wesentlichen gleichbleibenden Kanalquerschnitt, nämlich einen ersten Endabschnitt 42 und einen in Führungsrichtung F hinter dem ersten Endabschnitt 42 angeordneten zweiten Endabschnitt 44.

Der Leitungskanal 40 umfasst einen Aufnahmeabschnitt 46, der zwischen den Endabschnitten 42, 44 angeordnet ist und in welchen der Stromwandler 60 aufgenommen ist. Der Stromwandler 60 ist derart in dem Aufnahmeabschnitt 46 aufgenommen, dass ein in Führungsrichtung F in den Leitungskanal 40 eingeführter Phasenleiter L derart an dem Stromwandler 60 vorbeigeführt ist oder durch den Stromwandler 60 hindurch geführt ist, dass der Stromwandler 60 geeignet ist, auf der Signalleitung ein elektrisches Signal bereit zu stellen, welches die in dem Phasenleiter L fließende Stromstärke abbildet.

Durch die anmeldungsgemäße Ausgestaltung der Befestigungseinrichtung 10 kann eine einfache Montage erfolgen, in dem durch einfaches mechanisches Hindurchschleifen des oder der Phasenleiter(s) durch die Leitungskanäle 40 an der Befestigungseinrichtung 10 ein elektrisches Signal bereit gestellt werden kann, welches die in dem oder den Phasenleitern L fließende Stromstärke abbildet und an den Elektrizitätszähler 100 weitergibt. Der Phasenleiter L kann dabei insbesondere als biegsames Kabel mit wenigstens einer Ader A und einer um die Ader A angeordneten Isolierung ausgebildet sein. Durch diese Ausgestaltung kann die in der Ader A fließende Stromstärke durch den Stromwandler 60 gemessen werden, ohne dass die Isolierung des Kabels zuvor entfernt werden muss. Durch diese Ausgestaltung lässt sich das Kabel in einfacher Weise mit dem Stromwandler 60 in Wirkverbindung bringen, indem jedes einer Phase entsprechende Kabel durch den korrespondierenden Leitungskanal 40 gezogen wird.

Jeder Leitungskanal 40, insbesondere der erste Endabschnitt 42 jedes Leitungskanals kann ausgebildet sein, um das biegsame Kabel gegenüber des Stromwandlers 60 auszurichten, d.h., um das biegsame Kabel an seine bestimmungsgemäße Endlage durch den Stromwandler 60 hindurch oder an diesem vorbei zu führen. Dabei kann der Kanalquerschnitt insbesondere kreisförmig ausgebildet sein und das Kabel einen kreisförmigen Querschnitt aufweisen.

Das Kabel kann eine Kabelquerschnittsfläche aufweisen, die zwischen 2,5 mm² und 35 mm², vorzugsweise zwischen 10 mm² und 16 mm² beträgt.

Vorzugsweise ist die Kabelquerschnittsfläche kleiner als eine Querschnittsfläche der Endabschnitte 42, 44.

In einer bevorzugten Ausgestaltung weist der Aufnahmeabschnitt 46 einen von den Endabschnitten 42, 44 verschiedenen Querschnitt auf. Vorzugsweise ist der den Stromwandler 60 formschlüssig in dem Aufnahmeabschnitt 46 aufgenommen. Weiterhin vorzugsweise ist der Stromwandler 60 in und entgegen der Führungsrichtung F formschlüssig in dem Aufnahmeabschnitt 46 gehalten.

Die Leitungsführungseinrichtung 20 kann zudem für den zu führenden Neutralleiter L einen weiteren Leitungskanal 40 aufweisen, der frei von einem Aufnahmeabschnitt 46 und/oder einer Strommesseinrichtung und/oder eines Stromwandlers 60 ist.

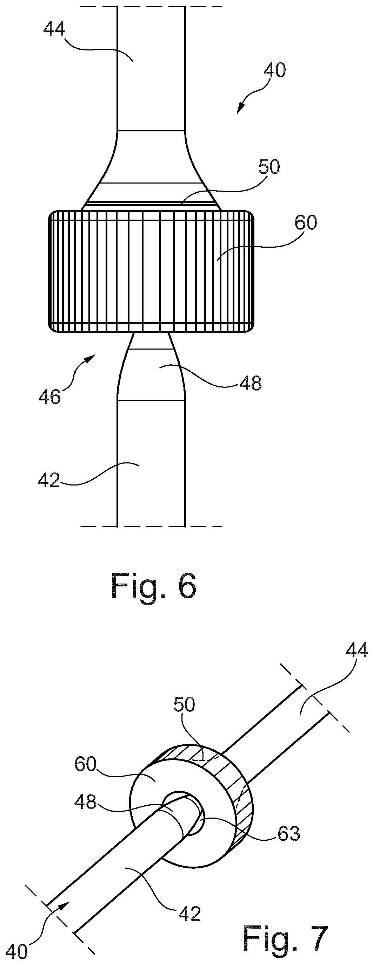

Der Stromwandler, der insbesondere in den Figuren 6 und 7 zu erkennen ist, kann torusförmig ausgebildet sein und derart in dem Aufnahmeabschnitt 46 aufgenommen sein, dass ein in Führungsrichtung F in den Leitungskanal 40 eingeführter Phasenleiter L durch eine Öffnung 63 des Stromwandlers 60 hindurch geführt ist.

Der Stromwandler kann derart in dem Aufnahmeabschnitt 46 aufgenommen sein, dass die Öffnung 63 mit dem Leitungskanal 40 und/oder den Endabschnitten 42, 44 fluchtet.

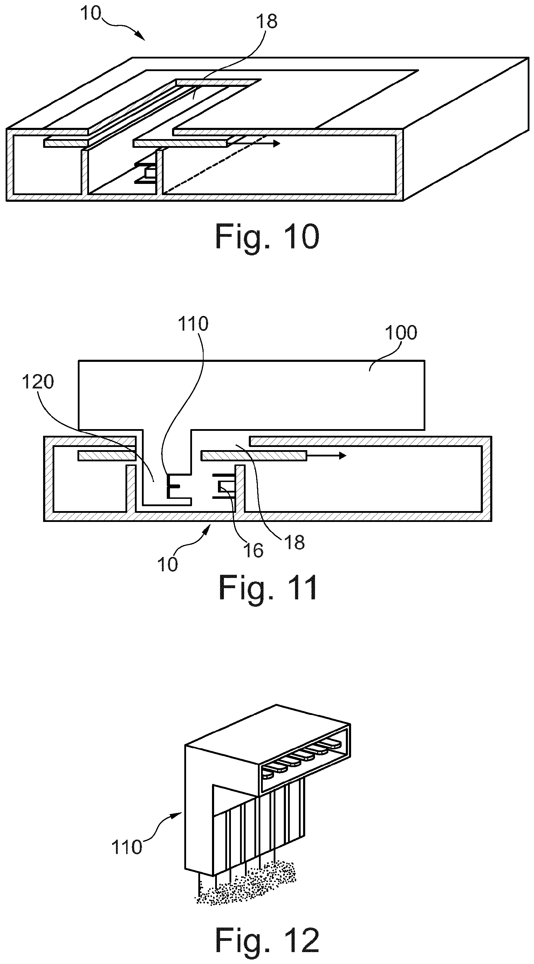

Wie insbesondere die Figuren 10 und 11 zu erkennen geben, kann die Befestigungseinrichtung eine Steckerleiste 16 umfassen, die weiterhin vorzugsweise zehnpolig ausgestattet ist. Der elektronische Elektrizitätszähler 100 kann mit einer Anschlussleiste 110 versehen sein, der mit der Steckerleiste 16 verbindbar ist.

Vorzugsweise ist die Anschlussleiste 110 des elektronischen Elektrizitätszählers 100 ebenfalls zehnpolig ausgestaltet.

Vorzugsweise ist jedes der Pole der Anschlussleiste 110 stiftförmig ausgebildet und die einzelnen Pole der Steckerleiste 16 hülsenförmig ausgebildet. Die Anschlussleiste 110 kann mit der Steckerleiste 16 verbunden werden, in dem ein Fortsatz 120 des elektronischen Elektrizitätszählers 100 in ein Fenster 18 der Befestigungseinrichtung 10 eingeführt wird und der elektronische Elektrizitätszähler 100 mittels eines Verschiebebewegung entlang einer Vorderseite der Befestigungseinrichtung 10 bewegt wird.

In einer bevorzugten Ausgestaltung ist zwischen dem ersten Endabschnitt 42 und dem Aufnahmeabschnitt 46 ein erster Ausrichtungsabschnitt 48 angeordnet, der den durch den ersten Endabschnitt 42 in Führungsrichtung F eingeführten Phasenleiter L derart ausrichtet, dass dieser in Führungsrichtung F an dem Stromwandler 60 vorbeigeführt oder durch den Stromwandler 60 hindurch geführt, vorzugsweise durch die Öffnung 63 des Stromwandlers 60 geführt werden kann.

Zwischen dem Aufnahmeabschnitt 46 und dem zweiten Endabschnitt 44 kann ein zweiter Ausrichtungsabschnitt 50 angeordnet sein, der den durch den ersten Endabschnitt 42, den Aufnahmeabschnitt 46 und vorzugsweise die Öffnung 63 in Führungsrichtung F eingeführten Phasenleiter L derart ausrichtet, dass dieser in Führungsrichtung F in den zweiten Endabschnitt 44 geführt werden kann.

Der erste Ausrichtungsabschnitt 48 und der zweite Ausrichtungsabschnitt 50 können im Wesentlichen trichterförmig oder kegelförmig ausgebildet sein. Dies wird insbesondere aus den Figuren 3 bis 5 ersichtlich.

Der erste Ausrichtungsabschnitt 48 und/oder der zweite Ausrichtungsabschnitt 50 können abschnittsweise an dem Stromwandler 60 anliegen, um den Stromwandler 60 in oder entgegen der Führungsrichtung F formschlüssig zu halten. Diese Ausgestaltung wird insbesondere aus den Figuren 3 und 6 ersichtlich.

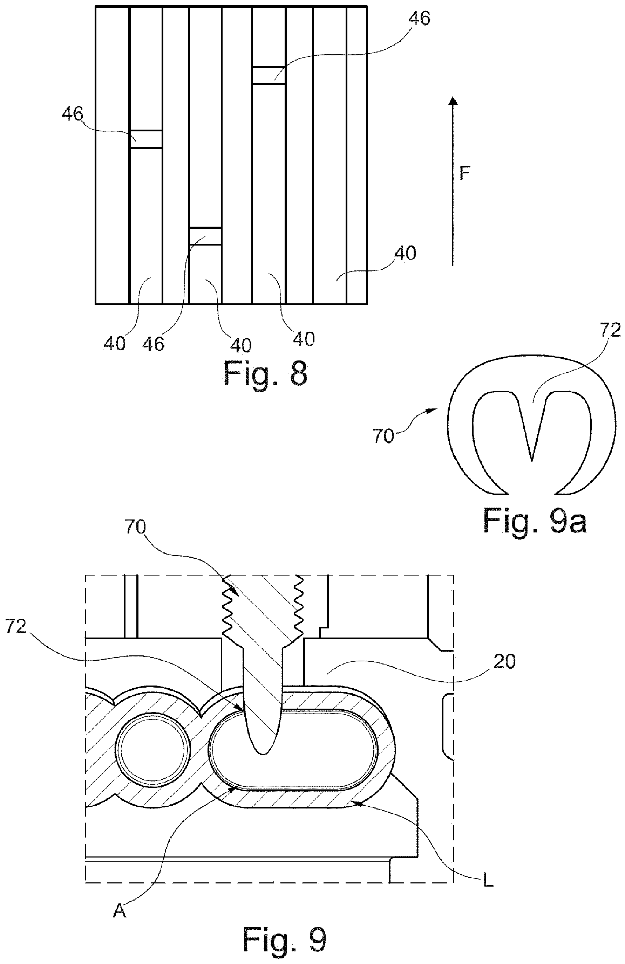

Vorzugsweise umfasst die Befestigungseinrichtung 10 wenigstens zwei Leitungskanäle 40, wobei der Aufnahmeabschnitt 46 zweier benachbarter Leitungskanäle 40 in Führungsrichtung F zueinander versetzt angeordnet sind. Diese Ausgestaltung wird insbesondere aus der Figur 8 ersichtlich.

Somit sind die Stromwandler 60 derart voneinander beanstandet, dass die Leitungskanäle 40 näher aneinander gerückt werden können und die Befestigungseinrichtung 10 insgesamt kompakter ausgeführt werden kann.

Die Befestigungseinrichtung 10 kann eine Spannungsabgriffsvorrichtung 70 mit einem Dorn aufweisen. Diese Spannungsabgriffsvorrichtung 70 dient zum Abgriff einer in einer Ader A des Phasenleiters L vorherrschenden Spannung. Die Spannungsabgriffsvorrichtung 70 ist insbesondere in den Figuren 9 und 9a wiedergegeben.

Die Spannungsabgriffsvorrichtung 70 kann innerhalb der Befestigungseinrichtung 10 derart angeordnet sein, dass der Dorn 22 in den Leitungskanal 40 hineinragt, um zum Abgriff der in der Ader A des Phasenleiters vorherrschenden Spannung in den Phasenleiter L einzudringen.

In einer bevorzugten Ausgestaltung umfasst die Befestigungseinrichtung 10 eine Kontaktiereinrichtung, die geeignet ist, mit einer Anschlusseinrichtung des Elektrizitätszählers 100 verbunden zu werden. Weiterhin vorzugsweise ist die Kontaktiereinrichtung mit der Signalleitung und/oder der Spannungssignalleitung verbunden, um das Spannungssignal oder die in der Ader des Phasenleiters vorherrschenden Spannung auf dem Elektrizitätszähler 100 bereit zu stellen.

Die Signalleitung des Stromwandlers 60 kann einen Schalter umfassen, vorzugsweise einen Mikroschalter, der geeignet ist, den durch die Signalleitung gebildeten Sekundärstromkreis zu öffnen und/oder zu schließen.

Somit kann der Schalter vor dem Anschluss des elektronischen Elektrizitätszählers 100 an die Befestigungseinrichtung 10 den durch die Signalleitung gebildeten Sekundärstromkreis geschlossen halten, um etwaige gefährlich hohe in dem Sekundärstromkreis auftretende Spannungen zu verhindern. Dies wird dadurch erreicht, dass der Sekundärstromkreis einen Kurzschluss bildet. Der Schalter kann geöffnet werden, wenn die Anschlusseinrichtung des Elektrizitätszählers 100 mit der Kontaktiereinrichtung der Befestigungseinrichtung 10 verbunden ist. Dies kann beispielsweise mittels einer Verschiebebewegung des Elektrizitätszählers 100 auf der Befestigungseinrichtung 10 erfolgen, insbesondere dann, wenn der Elektrizitätszähler 100 zum Einrasten des wenigstens einen Hakenelements 102 des Elektrizitätszählers 100 in die wenigstens eine Befestigungsöffnung 11 entlang der Befestigungseinrichtung 10 verschoben wird.

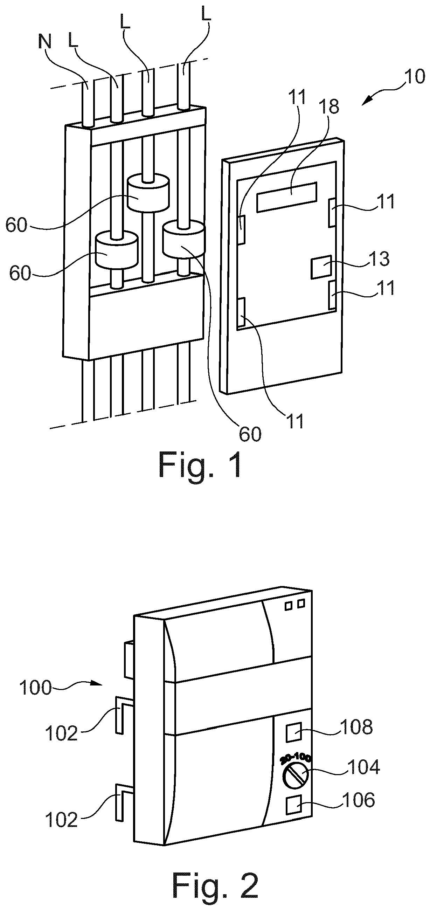

In einer bevorzugten Ausgestaltung, die insbesondere in Figur 2 wiedergegeben ist, kann der Elektrizitätszähler mit einer Stellschraube 104 versehen sein und der Elektrizitätszähler 100 ausgebildet sein, anhand einer Stellung der Stellschraube 104 einen Umrechnungsfaktor, der dem Verhältnis zwischen der in der Signalleitung fließende Stromstärke und der in dem korrespondierenden Phasenleiter L fließenden Stromstärke entspricht, zu bestimmen. Weiterhin vorzugsweise umfasst die Stellschraube 104 des Elektrizitätszählers eine Plombiereinrichtung 106 zur Plombierung der Stellschraube 104 in ihrer Momentanstellung.

In einer weiteren bevorzugten Ausgestaltung umfasst der Elektrizitätszähler 100 eine Plombierungsvorrichtung 108 zur Plombierung des Elektrizitätszählers auf der Befestigungseinrichtung 10.

Selbstverständlich ist die Erfindung nicht auf die beschriebenen und dargestellten Ausführungsformen begrenzt. Änderungen, z. B. in den Ausführungsformen der verschiedenen Bestandteile oder Ersetzungen durch technische Äquivalente sind, soweit sie im Rahmen des beanspruchten Schutzbegehrens bleiben, jederzeit möglich.

## Patentansprüche

1. Befestigungseinrichtung zur Befestigung eines Elektrizitätszählers, insbesondere eines elektronischen Elektrizitätszählers (100), umfassend
eine Leitungsführungseinrichtung (20) zur Führung wenigstens eines Phasenleiters (L) und
wenigstens eine eine Signalleitung umfassende Strommesseinrichtung,
wobei die Leitungsführungseinrichtung (20) für jeden zu führenden Phasenleiter (L) einen Leitungskanal (40) aufweist, der sich im Wesentlichen entlang einer Führungsrichtung (F) erstreckt und zwei Endabschnitte (42, 44) mit einen in Führungsrichtung (F) im Wesentlichen gleichbleibenden Kanalquerschnitt umfasst, nämlich einen ersten Endabschnitt (42) und einen in Führungsrichtung (F) hinter dem ersten Endabschnitt (42) angeordneten zweiten Endabschnitt (44),
wobei der Leitungskanal (40) einen Aufnahmeabschnitt (46) umfasst, der zwischen den Endabschnitten (42, 44) angeordnet ist und in welchen die Strommesseinrichtung aufgenommen ist,
wobei die Strommesseinrichtung derart in dem Aufnahmeabschnitt (46) aufgenommen ist, dass ein in Führungsrichtung (F) in den Leitungskanal (40) eingeführter Phasenleiter (L) derart an der Strommesseinrichtung vorbeigeführt ist oder durch die Strommesseinrichtung hindurch geführt ist, dass die Strommesseinrichtung geeignet ist, auf der Signalleitung ein elektrisches Signal bereit zu stellen, welches die in dem Phasenleiter (L) fließende Stromstärke abbildet.

2. Befestigungseinrichtung nach Anspruch 1, **dadurch gekennzeichnet, dass** die Strommesseinrichtung als Stromwandler (60) ausgebildet ist.

3. Befestigungseinrichtung nach Anspruch 2, **dadurch gekennzeichnet, dass** der Stromwandler (60) torusförmig ausgebildet ist und derart in dem Aufnahmeabschnitt (46) aufgenommen ist, dass ein in Führungsrichtung (F) in den Leitungskanal (40) eingeführter Phasenleiter (L) durch eine Öffnung (63) des Stromwandlers (60) hindurch geführt ist,
wobei vorzugsweise der Stromwandler (60) derart in dem Aufnahmeabschnitt (46) aufgenommen ist, dass die Öffnung (63) mit dem Leitungskanal (40) und/oder den Endabschnitten (42, 44) fluchtet.

4. Befestigungseinrichtung nach einem der Ansprüche 1 bis 3, **dadurch gekennzeichnet, dass** zwischen dem ersten Endabschnitt (42) und dem Aufnahmeabschnitt (46) ein erster Ausrichtungsabschnitt (48) angeordnet ist, der den durch den ersten Endabschnitt (42) in Führungsrichtung (F) eingeführten Phasenleiter (L) derart ausrichtet, dass dieser in Führungsrichtung (F) an der Strommesseinrichtung vorbeigeführt oder durch die Strommesseinrichtung hindurch geführt, vorzugsweise durch die Öffnung (63) geführt werden kann.

5. Befestigungseinrichtung nach einem der Ansprüche 1 bis 4, **dadurch gekennzeichnet, dass** zwischen dem Aufnahmeabschnitt (46) und dem zweiten Endabschnitt (44) ein zweiter Ausrichtungsabschnitt (50) angeordnet ist, der den durch den ersten Endabschnitt (42), den Aufnahmeabschnitt (46) und vorzugsweise die Öffnung (63) in Führungsrichtung (F) eingeführten Phasenleiter (L) derart ausrichtet, dass dieser in Führungsrichtung (F) in den zweiten Endabschnitt (44) geführt werden kann.

6. Befestigungseinrichtung nach einem der Ansprüche 4 oder 5, **dadurch gekennzeichnet, dass** der erste Ausrichtungsabschnitt (48) und/oder der zweite Ausrichtungsabschnitt (50) im Wesentlichen trichterförmig oder kegelförmig ausgebildet ist.

7. Befestigungseinrichtung nach einem der Ansprüche 3 bis 6, **dadurch gekennzeichnet, dass** der erste Ausrichtungsabschnitt (48) und/oder der zweite Ausrichtungsabschnitt (50) abschnittsweise an der Strommesseinrichtung anliegt, um die Strommesseinrichtung in und/oder entgegen der Führungsrichtung (F) formschlüssig zu halten.

8. Befestigungseinrichtung nach einem der Ansprüche 1 bis 7, **dadurch gekennzeichnet, dass** die Leitungsführungseinrichtung (20) zwei Halbschalen (12, 14) umfasst, die den Leitungskanal (40) bilden und vorzugsweise jeweils aus Kunststoff mittels Spritzguss hergestellt sind.

9. Befestigungseinrichtung nach einem der Ansprüche 1 bis 8, **gekennzeichnet durch** wenigstens zwei Leitungskanäle (40), wobei der Aufnahmeabschnitt (46) zweier benachbarter Leitungskanäle (40) in Führungsrichtung (F) zueinander versetzt angeordnet sind.

10. Befestigungseinrichtung nach einem der Ansprüche 1 bis 9, **gekennzeichnet durch** wenigstens eine Spannungsabgriffsvorrichtung (70) mit einem Dorn (72), wobei die Spannungsabgriffsvorrichtung (70) derart angeordnet ist, dass der Dorn (72) in den Leitungskanal (40) hineinragt, um zum Abgriff einer in einer Ader (A) des Phasenleiters (L) vorherrschenden Spannung in den Phasenleiter (L) einzudringen.

11. Befestigungseinrichtung nach einem der Ansprüche 1 bis 9, **gekennzeichnet durch** wenigstens eine Spannungsbestimmungsvorrichtung umfassend wenigstens eine eine Spannungssignalleitung umfassende Spannungsmesseinrichtung, wobei die Spannungsmesseinrichtung derart in der Leitungsführungseinrichtung (20) aufgenommen ist, dass ein in Führungsrichtung (F) in den Leitungskanal (40) eingeführter Phasenleiter (L) derart an der Spannungsmesseinrichtung vorbeigeführt ist oder durch die Spannungsmesseinrichtung hindurch geführt ist, dass die Spannungsmesseinrichtung geeignet ist, auf der Spannungssignalleitung ein elektrisches Signal bereit zu stellen, welches die in einer Ader (A) des Phasenleiters (L) vorherrschende Spannung abbildet.

12. Befestigungseinrichtung nach einem der Ansprüche 10 oder 11, **dadurch gekennzeichnet, dass** die Spannungssignalleitung oder die Spannungsabgriffsvorrichtung (70) elektrisch leitend mit der Signalleitung der Strommesseinrichtung verbunden ist, um das Spannungssignal oder die in der Ader (A) des Phasenleiters (L) vorherrschenden Spannung auf der Signalleitung der Strommesseinrichtung bereit zu stellen.

13. Befestigungseinrichtung nach einem der Ansprüche 1 bis 12, **dadurch gekennzeichnet, dass** die Signalleitung einen Schalter, vorzugsweise einen Mikroschalter umfasst, der geeignet ist, den durch die Signalleitung gebildeten Sekundärstromkreis zu öffnen und/oder zu schließen.
